# EUROPEAN PATENT SPECIFICATION

(11) **EP 1 994 812 B1**
(45) Date of publication and mention of the grant of the patent: **10.07.2013**
(21) Application number: 06748305.7
(22) Date of filing: 03.03.2006
(51) Int. Cl.: G03B 21/16

(54) **COOLING STRUCTURE FOR HEAT GENERATING DEVICE**
KÜHLSTRUKTUR FÜR EINE WÄRMEERZEUGENDE EINRICHTUNG
STRUCTURE DE REFROIDISSEMENT POUR SYSTÈME PRODUISANT DE LA CHALEUR

(43) Date of publication of application: 26.11.2008
(73) Proprietor: TTE Technology, Inc., Indianapolis, IN 46206 (US)
(72) Inventor: CADIO, Michel, Carmel, Indiana 46032 (US)
(74) Representative: Chamberlain, Alan James
(86) International application number: PCT/US2006/008017
(87) International publication number: WO 2007/100337

(56) References cited:
- JP-A- 10 340 137
- US-A1- 2003 053 004
- US-A1- 2006 066 761
- US-B1- 6 459 577

## Description

### FIELD OF THE INVENTION

The present invention relates generally to the removal from heat from electronic devices. More specifically, the present invention relates to an improved cooling structure that removes heat from an enclosure such as a projection television system.

### BACKGROUND OF THE INVENTION

This section is intended to introduce the reader to various aspects of art, which may be related to various aspects of the present invention that are described and/or claimed below. This discussion is believed to be helpful in providing the reader with background information to facilitate a better understanding of the various aspects of the present invention. Accordingly, it should be understood that these statements are to be read in this light, and not as admissions of prior art.

Many components that make up electronic devices or systems such as projection televisions generate heat during normal operation. It is typically desirable to disperse generated heat to prevent overheating and facilitate efficient operation of the system. An example of an electronic component that generates a large amount of heat in an associated system is a high power lamp in a digital light projection (DLP) or liquid crystal display (LCD) television system. The high power lamp is used to generate a video display for viewing by a user.

Many systems comprise enclosures into which electrical and/or electronic components are placed in very close proximity to reduce overall system size. In such systems, space within the enclosure is at a premium. Dispersing heat from a high-power lamp disposed in a relatively confined television system enclosure is a difficult challenge.

This problem is compounded by a further need to meet standard requirements on many consumer electronic devices. For example, rigorous standards on many aspects of device operation are imposed by organizations such as Underwriters Laboratories (UL). One such requirement relates to the temperature of external surfaces of the device, which must remain cool enough to prevent injury to users of the system. This means that heat may not be dispersed from a device through an external surface at a rate that would cause the temperature of the external surface to exceed maximum UL temperature requirements.

An additional design constraint is overall system cost. Materials that are able to effectively disperse heat while remaining cool are relatively expensive. A system and method that effectively disperses heat generated in an enclosure in a cost-effective manner while also facilitating compliance with external surface temperature requirements is desirable.

US 2003/0053004 discloses a projection television which includes: a lamp for providing a light source; a circuit driving unit for supplying electric power; a cooling fan for cooling heat generated in the lamp and the circuit driving unit; a duct for inducing an air drawn in by the cooling fan and for externally discharging the air; and a resonator installed on the duct, for removing noise generated by the cooling fan.

An alternative cooling mechanism is described in JP 10 340137, which comprises a chimney-shaped rising part that has its horizontal and vertical widths smaller than at least the width of a processor housing and that extends downward in a prescribed length, and a chimney-shaped air leading part that is bent under the rising part and also horizontally extends from the base of the rising part.

### SUMMARY OF THE INVENTION

Certain aspects commensurate in scope with the disclosed embodiments are set forth below. It should be understood that these aspects are presented merely to provide the reader with a brief summary of certain forms the invention might take and that these aspects are not intended to limit the scope of the invention. Indeed, the invention may encompass a variety of aspects that may not be set forth below.

The disclosed embodiments relate to a system and method that is adapted to cool a heat generating device. An electronic device in accordance with an exemplary embodiment of the present invention comprises an enclosure that contains a source of heat, wherein the enclosure comprises an opening through which air heated by the source of heat is exhausted; and a cooling chimney structure creating a Venturi air flow and disposed over the opening of the enclosure such that access from outside the enclosure to the opening of the enclosure is at least partially blocked by the cooling structure, the cooling structure comprising: an internal intake opening adapted to receive an internal intake of heated air from the opening of the enclosure; a first external intake opening adapted to receive an external intake of air from outside the enclosure; and an air exhaust opening adapted to expel an exhaust, wherein the exhaust comprises a mixture of the internal intake of said heated air and the external intake of said air from outside.

### BRIEF DESCRIPTION OF THE DRAWINGSAdvantages of the invention may

become apparent upon reading the following detailed description and upon reference to the drawings in which:
FIG. 1 is a perspective view, including a blown up portion, of an electronic enclosure in accordance with an exemplary embodiment of the present invention;
FIG. 2 is a cutaway view of an electronic enclosure in accordance with an exemplary embodiment of the present invention; and
FIG. 3 is a flow chart of a method in accordance with exemplary an embodiment of the present invention.

### DETAILED DESCRIPTION

One or more specific embodiments of the present invention will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

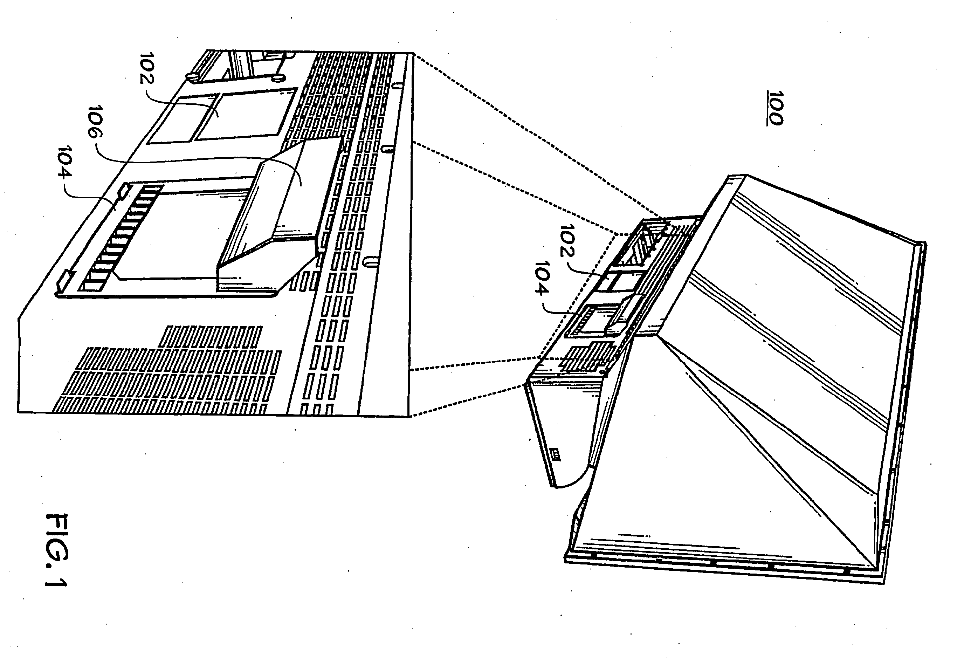

FIG. 1 is a perspective view, including a blown up portion, of an electronic enclosure in accordance with an exemplary embodiment of the present invention. The enclosure, which may comprise a projection television system, is generally referred to by the reference number 100. The enclosure 100 comprises a chassis cover 102. The chassis cover 102 allows access to the internal components contained in the enclosure 100.

A lamp access door 104 is also disposed on the back of the enclosure 100. The lamp access door 104 provides access to a lamp to facilitate periodic replacement thereof. A cooling structure 106 is disposed adjacent to the lamp access door 104. As explained below, the cooling structure 106 is adapted to remove heat from inside the enclosure 100 via a chimney effect while preventing access by a user to portions of the enclosure 100 that may be hot enough to cause injury.

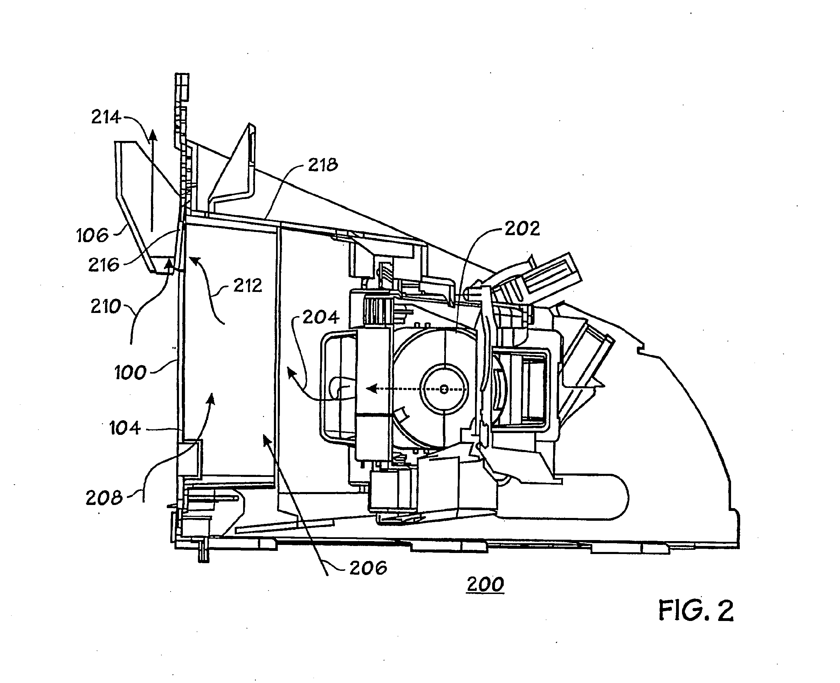

FIG. 2 is a cutaway view of the electronic enclosure 100 in accordance with an exemplary embodiment of the present invention. The cutaway diagram is generally referred to by the reference number 200. A lamp 202 is disposed inside the enclosure 100. The lamp 202 may comprise a high power bulb for use in generating an image that is displayed by a television system. The lamp 202 produces radiated heat, as indicated by the arrow 204.

The enclosure 100 is adapted to provide several airflows to remove the radiated heat 204, while maintaining the enclosure 100 at a temperature that will reduce the likelihood of injury to a user. One source of airflow may be a fan (not shown) disposed inside the enclosure 100.

The enclosure 100 may include louvers in its floor to facilitate entry of a floor intake, as indicated by an arrow 206. The floor intake 206 is adapted to travel through the interior of the enclosure 100 to facilitate dispersal of the radiated heat 204 through the back of the enclosure 100.

A second airflow may be pulled from outside the enclosure 100 through louvers in the lamp access door 104. This airflow is indicated by an arrow 208 in FIG. 2. Like the floor intake 206, the louver intake 208 assists with moving the radiated heat 204 out of the enclosure 100 via its back. A tunnel 218 may be disposed within the enclosure 100 to contain the radiated heat 204 and the various airflows within a relatively restricted portion of the enclosure 100.

In the exemplary embodiment illustrated in FIG. 2, the cooling structure 106 is disposed adjacent to the enclosure 100 and external thereto. The cooling structure 106 is adapted to receive an external chimney intake 210 from outside the enclosure 100. In addition, the cooling structure 106 is adapted to receive an internal chimney intake 212 from inside the enclosure 100. The cooling structure 106 may be formed integrally with the lamp access door 104 or the chassis of the enclosure 100. Alternatively, the cooling structure 106 may be a separate piece disposed adjacent to the enclosure 100.

In the exemplary embodiment illustrated in FIG. 2, the cooling structure is adapted to receive the internal chimney intake 212 through a plurality of louvers 216. The external chimney intake 210 mixes with the internal chimney intake 212 to create a Venturi flow within the cooling structure 106. This Venturi flow acts to effectively remove the radiated heat 204 from within the enclosure 100. The cooling structure 106 expels the mixture of the external chimney intake 210 and the internal chimney intake 212 via a chimney exhaust 214.

In the exemplary embodiment illustrated in FIG. 2, the cooling structure 106 is disposed such that it poses an obstacle to touching the louvers 216 by a user of the system. This feature makes it more difficult for a user to touch the louvers 216, which may be hot enough to cause injury. Thus, the cooling structure 106 helps to disperse the radiated heat 204 from within the enclosure 100, while reducing the chances of accidental injury to a user who may touch the enclosure 100. In addition, the cooling structure 106 may be positioned to reduce the undesirable escape via the louvers 216 of light rays emitted by the lamp 202 from within the enclosure 100.

Exemplary embodiments of the present invention further allow construction of the enclosure 100 with materials that have a relatively low heat resistance. For example, an exemplary embodiment of the present invention may allow the chassis cover 102 (FIG. 1) and/or the tunnel 218 to be constructed of a relatively low heat resistance material, which typically would cost less than a similar material having a higher heat resistance.

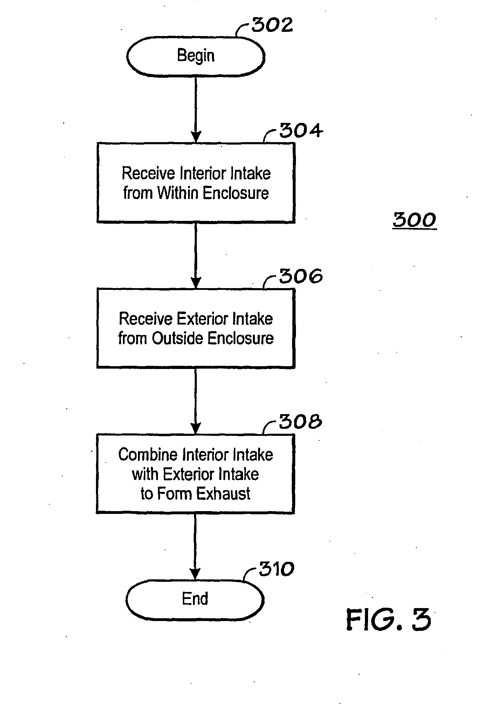

FIG. 3 is a flow chart of a method in accordance with exemplary an embodiment of the present invention. The process is generally referred to by the reference number 300. At block 302, the process begins. An interior intake, such as the interior intake 212 (FIG. 2) is received from within the enclosure 100 (FIG. 2) at block 304. As set forth above, the enclosure 100 (FIG. 2) may comprise a portion of an electronic device, such as a projection television. At block 306, an exterior intake, such as the exterior intake 210 (FIG. 2) is received from outside the enclosure 100 (FIG. 2). The interior intake 212 (FIG. 2) received at block 304 is combined with the exterior intake 210 (FIG. 2) received from outside the enclosure 100 (FIG. 2), as indicated at block 308. This combination forms an exhaust flow 214 (FIG. 2), which assists in dispersing heat from inside the enclosure 100 (FIG. 2). As set forth above, the combination of the interior intake 212 (FIG. 2) with the exterior intake 210 (FIG. 2) in a cooling structure such as the cooling structure 106 (FIG. 2) may form a Venturi flow, which assists in the removal of radiated heat 204 (FIG. 2) from within the enclosure 100 (FIG. 2). At block 310, the process end.

While the invention may be susceptible to various modifications and alternative forms, specific embodiments have been shown by way of example in the drawings and will be described in detail herein. However, it should be understood that the invention is not intended to be limited to the particular forms disclosed. Rather, the invention is to cover all modifications, equivalents and alternatives falling within the scope of the invention as defined by the following appended claims.

## Claims

1. An electronic device (100), comprising:
an enclosure (100) that contains a source of heat (202), wherein the enclosure (100) comprises an opening through which air heated by the source of heat is exhausted; and
a cooling chimney structure (106) creating a Venturi air flow and disposed over the opening of the enclosure (100) such that access from outside the enclosure (100) to the opening of the enclosure is at least partially blocked by the cooling structure (106), the cooling structure comprising:
an internal intake opening adapted to receive an internal intake (212) of heated air from the opening of the enclosure (100);
a first external intake opening adapted to receive an external intake (210) of air from outside the enclosure (100); and
a chimney exhaust opening adapted to expel an exhaust (214), wherein the exhaust (214) comprises a mixture of the internal intake (212) of said heated air and the external intake (210) of said an from outside.

2. The electronic device (100) recited in claim 1, wherein the enclosure (100) comprises a second external intake opening adapted to draw to the source of heat a second external intake (208) of air from outside the enclosure (100) that combines with the air heated by the source of heat (202).

3. The electronic device (100) recited in claim 2, wherein the enclosure (100) comprises a third external intake opening adapted to draw to the source of heat a third external intake (206) of air from outside the enclosure (100) that combines with the air heated by the source of heat (202) and the second external intake (208) of air.

4. The electronic device (100) recited in claim 1, wherein the electronic device (100) comprises a projection television system.

5. The electronic device (100) recited in claim 1, wherein the source of heat (202) comprises a lamp.

6. The electronic device (100) recited in claim 1, wherein the cooling structure (106) is formed as an integral portion of the enclosure (100).

7. The electronic device (100) recited in claim 1, wherein the opening of the enclosure (100) comprises at least one louver (216).

8. A method of cooling an enclosure (100) of an electronic device (100) containing a heat source (202), comprising the following steps:
drawing an internal intake (212) of heated air heated by the heat source (202) from an opening of the enclosure (100) into a cooling chimney structure (106) through an internal intake opening of the cooling chimney structure (106) disposed over the opening of the enclosure (100);
drawing an external intake (210) of air from outside the enclosure (100) into the cooling chimney structure (106) through an external intake opening of the cooling chimney structure (106); and
mixing the internal intake (212) of said heated air with the external intake (210) of said air from outside to form an exhaust (214); and
expelling the exhaust (214) through a chimney exhaust opening of the cooling chimney structure so that of creator a Venture air flow;
wherein access from outside the enclosure (100) to the opening of the enclosure is at least partially blocked by the cooling chimney structure (106).

9. The method recited in claim 8, comprising:
drawing a second external intake (208) of air from outside the enclosure (100) into the enclosure (100) through a second external intake opening of the enclosure; and
mixing the second external intake (208) of air with air heated by the source of heat (202).

10. The method recited in claim 9, comprising:
drawing a third external intake (206) of air from outside the enclosure (100) into the enclosure (100) through a third external intake opening of the enclosure; and
mixing the third external intake (206) of air with air heated by the source of heat (202) and the second external intake (208) of air.

## Patentansprüche

1. Elektronikvorrichtung (100), umfassend:
ein Gehäuse (100), das eine Wärmequelle (202) enthält, wobei das Gehäuse (100) eine Öffnung umfasst, durch die die durch die Wärmequelle erwärmte Luft entweicht; und
eine Kühlkaminstruktur (106), die einen Venturi-Luftstrom erzeugt und die derart über der Öffnung des Gehäuses (100) angeordnet ist, dass der Zugang von außerhalb des Gehäuses (100) zur Öffnung des Gehäuses zumindest partiell durch die Kühlstruktur (106) blockiert wird, wobei die Kühlstruktur umfasst:
eine innere Einlassöffnung, die dazu ausgelegt ist, dass sie einen inneren Zustrom (212) von Warmluft aus der Öffnung des Gehäuses (100) aufnimmt;
eine erste äußere Einlassöffnung, die dazu ausgelegt ist, dass sie einen äußeren Luft-Zustrom (210) von außerhalb des Gehäuses (100) aufnimmt; und
eine Kaminabluftöffnung, die dazu ausgelegt ist, dass sie die Abluft (214) ausstößt, wobei die Abluft (214) ein Gemisch des inneren Zustroms (212) der Warmluft und des äußeren Zustroms (210) der Außenluft umfasst.

2. Elektronikvorrichtung (100) nach Anspruch 1, wobei das Gehäuse (100) eine zweite äußere Einlassöffnung umfasst, die dazu ausgelegt ist, dass zur Wärmequelle ein zweiter äußerer Zustrom (208) von Luft von außerhalb des Gehäuses (100) gesogen wird, die sich mit der durch die Wärmequelle (202) erwärmten Luft vereinigt.

3. Elektronikvorrichtung (100) nach Anspruch 2, wobei das Gehäuse eine dritte äußere Einlassöffnung umfasst, die dazu ausgelegt ist, dass zur Wärmequelle ein dritter äußerer Zustrom (206) von Luft von außerhalb des Gehäuses (100) gesogen wird, die sich mit der durch die Wärmequelle (202) erwärmten Luft und dem zweiten äußeren Zustrom (208) von Luft vereinigt.

4. Elektronikvorrichtung (100) nach Anspruch 1, wobei die Elektronikvorrichtung (100) ein Projektionsfernsehsystem umfasst.

5. Elektronikvorrichtung (100) nach Anspruch 1, wobei die Wärmequelle (202) eine Lampe umfasst.

6. Elektronikvorrichtung (100) nach Anspruch 1, wobei die Kühlstruktur (106) als einstückiger Teil des Gehäuses (100) gebildet wird.

7. Elektronikvorrichtung (100) nach Anspruch 1, wobei die Öffnung des Gehäuses (100) mindestens eine Lüftungsöffnung (216) umfasst.

8. Verfahren zum Kühlen eines Gehäuses (100) einer Elektronikvorrichtung (100) mit einer Wärmequelle (202), umfassend die folgenden Schritte:
Ansaugen eines inneren Zustroms (212) der durch die Wärmequelle (202) erwärmten Warmluft aus einer Öffnung des Gehäuses (100) in eine Kühlkaminstruktur (106) durch eine interne Einlassöffnung der Kühlkaminstruktur (106), die über der Öffnung des Gehäuses (100) angeordnet ist;
Ansaugen eines äußeren Luft-Zustroms (210) von außerhalb des Gehäuses (100) in die Kühlkaminstruktur (106) durch eine äußere Einlassöffnung der Kühlkaminstruktur (106); und
Mischen des inneren Zustroms (212) von Warmluft mit dem äußeren Zustrom (210) von Außenluft, so dass man die Abluft (214) erhält; und
Ausstoßen der Abluft (214) durch eine Kaminabluftöffnung der Kühlkaminstruktur, so dass sie einen Venturi-Luftstrom erzeugt,
wobei der Zugang von außerhalb des Gehäuses (100) zur Öffnung des Gehäuses zumindest partiell durch die Kühlkaminstruktur (106) blockiert wird.

9. Verfahren nach Anspruch 8, umfassend:
Ansaugen eines zweiten äußeren Luft-Zustroms (208) von außerhalb des Gehäuses (100) in das Gehäuse (100) durch eine zweite äußere Einlassöffnung des Gehäuses; und
Mischen des zweiten äußeren Zustroms (208) von Luft mit der durch die Wärmequelle (202) erwärmten Luft.

10. Verfahren nach Anspruch 9, umfassend:
Ansaugen eines dritten äußeren Luft-Zustroms (206) von außerhalb des Gehäuses (100) in das Gehäuse (100) durch eine dritte äußere Einlassöffnung des Gehäuses; und
Mischen des dritten äußeren Zustroms (206) von Luft mit der durch die Wärmequelle (202) erwärmten Luft und dem zweiten äußeren Zustrom (208) von Luft.

## Revendications

1. Dispositif électronique (100), comprenant :
une enceinte (100) qui contient une source de chaleur (202), où l'enceinte (100) comprend une ouverture à travers laquelle l'air chauffé par la source de chaleur est évacué ; et
une structure de cheminée de refroidissement (106) créant un écoulement d'air Venturi et disposée sur l'ouverture de l'enceinte (100) de sorte que l'accès depuis l'extérieur de l'enceinte (100) à l'ouverture de l'enceinte est au moins partiellement bloqué par la structure de refroidissement (106), la structure de refroidissement comprenant :
une ouverture d'admission interne apte à recevoir une admission interne (212) d'air chauffé de l'ouverture de l'enceinte (100) ;
une première ouverture d'admission externe apte à recevoir une admission externe (210) d'air depuis l'extérieur de l'enceinte (100) ; et
une ouverture d'évacuation de cheminée apte à expulser un échappement (214), où l'échappement (214) comprend un mélange d'admission interne (212) dudit air chauffé et l'admission externe (210) dudit air de l'extérieur.

2. Dispositif électronique (100) selon la revendication 1, dans lequel l'enceinte (100) comprend une deuxième ouverture d'admission externe apte à aspirer à la source de chaleur une deuxième admission externe (208) d'air depuis l'extérieur de l'enceinte (100) qui se combine avec l'air chauffé par la source de chaleur (202).

3. Dispositif électronique (100) selon la revendication 2, dans lequel l'enceinte (100) comprend une troisième ouverture d'admission externe apte à aspirer à la source de chaleur une troisième admission externe (206) d'air depuis l'extérieur de l'enceinte (100) qui se combine avec l'air chauffé par la source de chaleur (202) et la deuxième admission externe (208) d'air.

4. Dispositif électronique (100) selon la revendication 1, dans lequel le dispositif électronique (100) comprend un système de télévision de projection.

5. Dispositif électronique (100) selon la revendication 1, dans lequel la source de chaleur (202) comprend une lampe.

6. Dispositif électronique (100) selon la revendication 1, dans lequel la structure de refroidissement (106) est réalisée comme une portion intégrale de l'enceinte (100).

7. Dispositif électronique (100) selon la revendication 1, dans lequel l'ouverture de l'enceinte (100) comprend au moins un volet (216).

8. Procédé de refroidissement d'une enceinte (100) d'un dispositif électronique (100) contenant une source de chaleur (202), comprenant les étapes suivantes :
aspirer une admission interne (212) d'air chauffé, chauffé par la source de chaleur (202), d'une ouverture de l'enceinte (100) dans une structure de cheminée de refroidissement (106) à travers une ouverture d'admission interne de la structure de cheminée de refroidissement (106) disposée sur l'ouverture de l'enceinte (100) ;
aspirer une admission externe (210) d'air depuis l'extérieur de l'enceinte (100) dans la structure de cheminée de refroidissement (106) à travers une ouverture d'admission externe de la structure de cheminée de refroidissement (106) ; et
mélanger l'admission interne (212) dudit air chauffé avec l'admission externe (210) dudit air de l'extérieur pour former un échappement (214) ; et
expulser l'échappement (214) à travers une ouverture d'évacuation de cheminée de la structure de cheminée de refroidissement de manière à créer un écoulement d'air Venturi ;
où l'accès depuis l'extérieur de l'enceinte (100) à l'ouverture de l'enceinte est au moins partiellement bloqué par la structure de cheminée de refroidissement (106).

9. Procédé selon la revendication 8, comprenant :
aspirer une deuxième admission externe (208) d'air depuis l'extérieur de l'enceinte (100) dans l'enceinte (100) à travers une deuxième ouverture d'admission externe de l'enceinte ; et
mélanger la deuxième admission externe (208) d'air avec l'air chauffé par la source de chaleur (202).

10. Procédé selon la revendication 9, comprenant :
aspirer une troisième admission externe (206) d'air depuis l'extérieur de l'enceinte (100) dans l'enceinte (100) à travers une troisième ouverture d'admission externe de l'enceinte ; et
mélanger la troisième admission externe (206) d'air avec l'air chauffé par la source de chaleur (202) et la deuxième admission externe (208) d'air.
